## Europäisches Patentamt

## European Patent Office

## Office européen des brevets

(11) Veröffentlichungsnummer: **0 088 399**

**B1**

(12) # EUROPÄISCHE PATENTSCHRIFT

(45) Veröffentlichungstag der Patentschrift:
08.06.88

(51) Int. Cl.⁴: **H 01 L 29/78,** H 01 L 29/10

(21) Anmeldenummer: **83102143.1**

(22) Anmeldetag: **04.03.83**

(54) Spannungsfester MOS-Transistor für höchstintegrierte Schaltungen.

(30) Priorität: **09.03.82 DE 3208500**

(43) Veröffentlichungstag der Anmeldung:
**14.09.83 Patentblatt 83/37**

(45) Bekanntmachung des Hinweises auf die Patenterteilung:
**08.06.88 Patentblatt 88/23**

(84) Benannte Vertragsstaaten:
**AT BE DE FR GB IT NL SE**

(56) Entgegenhaltungen:
**IEDM 1974 INTERNATIONAL ELECTRON DEVICES MEETING, Nr. 23.6, 9.-11. December 1974, Seiten 550-553, The Institute of Electrical and Electronics Engineers, New York, US; W.S. JOHNSON et al.: "Design of short-channel ion-implanted mosfets with relatively junctions"**
**IEEE TRANSACTIONS ON ELCTRON DEVICES, Band ED-24, Nr. 3, Mars 1977, Seiten 196-204, New York, US; P.P. WANG: "Double boron implant short-channel MOSFET"**
**IBM TECHNICAL DISCLOSURE BULLETIN, Band 15, Nr. 10, March 1973, Seiten 3068-3069, New York, US; F. GAENSSLEN: "Ultra-short channel mosfet device"**
**IBM TECHNICAL DISCLOSURE BULLETIN, Band 15, Nr. 10, Mars 1978, Seiten 4178-4180, New York, US; E.F. MIERSCH et al: "FET structures for very high performance circuits operating at low**

(73) Patentinhaber: **Siemens Aktiengesellschaft Berlin und München, Wittelsbacherplatz 2, D-8000 München 2 (DE)**

(72) Erfinder: **Risch, Lothar, Dr., Gartenstrasse 20, D-8012 Ottobrunn (DE)**
Erfinder: **Tielert, Reinhard, Dr., Lehrer- Götz- Weg 24, D-8000 München 82 (DE)**
Erfinder: **Müller, Wolfgang, Dr., Theodor- Heuss- Strasse 12, D-8012 Putzbrunn (DE)**
Erfinder: **Werner, Christoph, Dr., Pentenriederstrasse 15, D-8033 Krailling (DE)**

(56) Entgegenhaltungen: (Fortsetzung)
**temperatures"**

EP 0 088 399 B1

## Beschreibung

Spannungsfester MOS-Transistor für
höchstintegrierte Schaltungen.

Die Patentanmeldung bezieht sich auf einen spannungsfesten MOS-Transistor für höchstintegrierte Schaltungen mit einem Halbleitersubstrat vom ersten Leitungstyp und einer darauf planar angeordneten epitaktischen Schicht, auf deren Oberfläche eine isolierende Schicht und darauf eine aus Polysilizium bestehende Gateelektrode angeordnet ist, und in der in den Oberflächenbereich hineinreichende stark-dotierte Source- und Drainzonen vom zweiten Leitungstyp erzeugt sind, und in der außerdem zwischen Source- und Drainzone ein als Kanalzone wirkendes Gebiet vom ersten Leitungstyp angeordnet ist, das in Richtung Substrat eine unterschiedliche Konzentration von implantierten Dotierstoffteilchen aufweist, sowie ein Verfahren zu seiner Herstellung.

Durch die fortschreitende Miniaturisierung der integrierten MOS-Schaltungen werden Transistoren mit Kanallängen kleiner 1,5 μm benötigt, welche den üblichen Betriebsspannungen von 5 V (- 2,5 V Substratspannung) genügen. Die daraus resultierende schlechte Reproduzierbarkeit der Einsatzspannung, bedingt durch Kanallängenschwankungen bzw. eine nicht ausreichende Spannungsfestigkeit infolge Lawinenmultiplikation, gekoppelt mit einem Bipolareffekt, stellt ein schwieriges technisches Problem dar.

Aus dem Stand der Technik (siehe Aufsatz von R. H. Dennard et al "Design of ion-implanted MOSFET's with very small physical dimensions" in IEEE Sol. State Circuits, Vol. SC-9, Seiten 256 bis 268, 1974) ist es bekannt, dieses Problem dadurch zu lösen, daß ein auf ein hochohmiges Substrat aufgebauter MOS-Transistor im Kanalbereich eine Doppelimplantation enthält und reduzierte Source/Drain-Eindringtiefen sowie ein dünnes Gateoxid aufweist.

Das Konzept der Doppelimplantation im Kanalbereich, wie es beispielsweise aus einer Arbeit von P. P. Wang aus dem IEEE, ED-24 (1977) auf den Seiten 196 bis 204 zu entnehmen ist, wird in der Praxis nicht voll genützt. Speziell wählt man für die tiefe Implantation eine viel kleinere Dosis als dies für die Abschirmung der Drainspannung gegenüber Source optimal wäre, um nicht die Durchbruchsspannungsfestigkeit des Transistors zu reduzieren.

Die Verwendung einer hochdotierten Substrats in Kombination mit einer niedrig dotierten epitaktischer Schicht vom gleichen Leitungstyp, die eine höher dotierte Kanalzone aufweist, ist bei Ultrakurzkanal-MOSFETs zum Zwecke der Begrenzung der Verarmungszonenausdehnung aus IBM TDB, Vol. 15, No. 10, März 1973, S. 3068-3069 bekannt.

Andere Konzepte wie doppelt-implantierte MOS-Strukturen, doppelt-diffundierte MOS-Strukturen, MOS-Strukturen mit vergrabenen Zonen, MOS-Strukturen mit getrennten Gates und schwach-dotierten Drain-Zonen sind ebenfalls zur Lösung des Problems bekannt, bringen aber als Nachteil eine größere Komplexität und eine schlechtere Reproduzierbarkeit der Langkanal-Einsatzspannung mit sich.

Es ist eine Aufgabe der vorliegenden Erfindung, einen MOS-Transistor für höchstintegrierte Schaltungen (Sub-μm-Bereich) anzugeben, der die Vorteile einer tiefen Implantation mit hoher Dosis auf den Kurzkanaleffekt der Einsatzspannung ausnutzt und dabei den Durchbruch des Transistors bei relativ niedrigen Drain-Spannungen vermeidet. Weiter ist es Aufgabe der vorliegenden Erfindung, ein möglichst einfach durchführbares Verfahren zur Herstellung eines derartigen MOS-Transistors anzugeben.

Diese Aufgabe wird erfindungsgemäß durch einen Transistor der eingangs genannten Art gelöst, der folgende Merkmale aufweist:

a)	Das Substrat vom ersten Leitungstyp ist niederohmig und die epitaktische Schicht ist hochohmig und vom gleichen Leitungstyp wie das Substrat;

b)	das Kanalgebiet vom ersten Leitungstyp weist in Richtung Substrat eine zu einem Konzentrationsmaximum ansteigende Dotierstoffkonzentration auf, wobei das Konzentrationsmaximum der implantierten Dotierstoffteilchen vom ersten Leitungstyp im Kanalgebiet vom ersten Leitungstyp eine größere Tiefe als die Source/Drainzonen vom zweiten Leitungstyp aufweist und sich bis in die unterhalb der Source/Drainzonen gelegenen Bereiche der epitaktischen Schicht erstreckt, so, daß das Gebiet mit dem Konzentrationsmaximum der implantierten Dotierstoffteilchen den Rand der Source/Drainzonen im Bereich der Gateelektrode umschließt und

c)	die epitaktische Schicht weist eine Schichtdicke auf, die maximal das Zehnfache der Tiefe der Source/Drainzonen, aber mindestens das Doppelte der Tiefe des Konzentrationsmaximums der in die Kanalzone implantierten Dotierstoffteilchen beträgt.

Weitere Ausgestaltungen und Weiterbildungen des Erfindungsgedankens ergeben sich aus den Unteransprüchen.

Folgende Überlegungen haben zu der Erfindung geführt: Durch den Einfluß der tiefen Implantation wird der Kurzkanaleffekt auf die Einsatzspannung stark reduziert. Bei Untersuchungen des Durchbruchverhaltens wurde festgestellt, daß bei Einsetzen der Lawinenmultiplikation vom Kanalstrom der zum Substrat abfließende Löcherstrom einen Spannungsabfall bewirkt. Dieser Spannungsabfall führt zu einer internen Vorspannung des MOS-Transistors, welche den Kanalstrom erhöht. Bei weiterer Erhöhung des Substratstroms tritt dann der eigentliche Bipolareffekt auf. Dabei übernimmt das Substrat die Rolle der Basis eines Bipolartransistors, so daß über die Schichtfolge nun entsprechend Emitter, Basis, Kollektor ein zusätzlicher Strom injiziert wird, der zum Durchbruch des MOS-Transistors führt.

Der erfindungsgemäße Transistor unterdrückt diesen vom Lawinenmultiplikationsstrom erzeugten Spannungsabfall dadurch, daß die MOS-Struktur auf niederohmigem Substrat und einer darauf befindlichen, dünnen, hochohmigen Epitaxieschicht aufgebaut wird. Dadurch werden die interne Vorspannung bzw. der Bipolareffekt weitgehend eliminiert und damit eine höhere Drainspannung des MOS-Transistors erreicht. Außerdem wird durch den Einsatz einer zusätzlichen Implantationsmaske bei der Kanalimplantation (vor der Source/Drain-Implantation) die Überlappung der Kanaldotierung mit dem Source/Drain-Gebieten reduziert und dadurch die Schaltgeschwindigkeit des Transistors erhöht. Dabei übernimmt die Epitaxieschicht die Realisierung der niedrigdotierten Zone.

Aus der nachfolgenden Beschreibung zu einem bevorzugten Ausführungsbeispiel der Erfindung, das anhand der Figuren gegeben wird, lassen sich weitere Erläuterungen zur Erfindung entnehmen. Dabei zeigen die Figuren 1 bis 4 im Schnittbild den Transistor nach Durchführung der einzelnen Verfahrensschritte und die Figuren 5 und 6 Schnitte durch charakteristische Transistorbereiche. Bei der Darstellung der Figuren sowie der Beschreibung ist der besseren Übersicht wegen auf benachbarte Bereiche des Transistors, wie z. B. die Darstellung der die aktiven Transistorbereiche trennenden Isolationsbereiche (LOCOS-Gebiete) verzichtet worden.

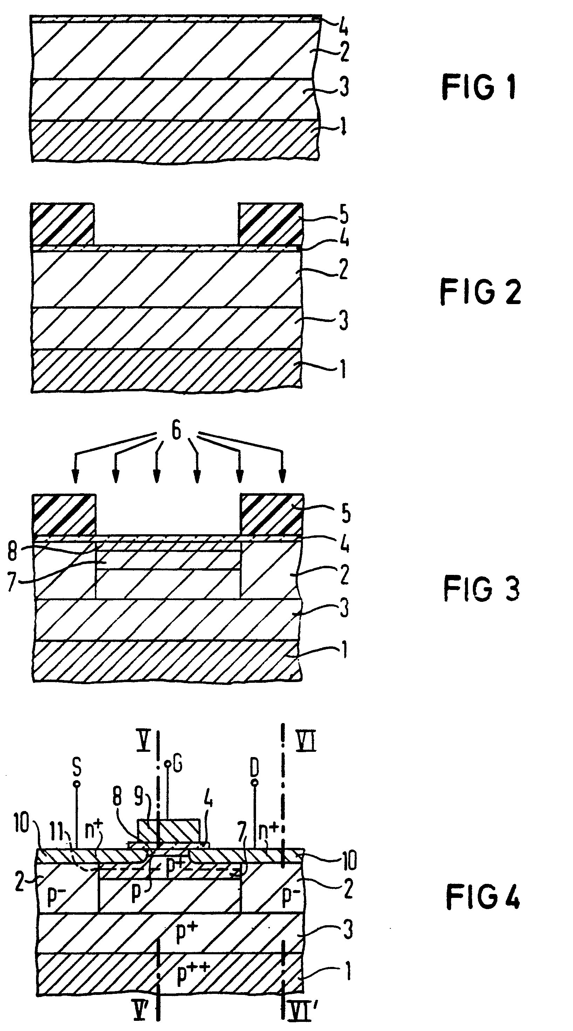

Anhand der Figuren 1 bis 4 wird die Herstellung eines n-Kanal-MOS-Transistors beschrieben. Dabei gelten in in allen Figuren für gleiche Teile die gleichen Bezugszeichen.

Fig 1 : Mit 1 ist ein hochdotierter Siliziumsubstratkörper (p++ $\approx 10^{17}$ cm$^{-3}$) von $\approx$ 500 µm Dicke bezeichnet, auf dessen Oberfläche eine niedriger dotierte epitaktische Siliziumschicht 2 (p$^-$ $\approx 1 \times 10^{15}$ cm$^{-3}$) in einer Schichtdicke von 2 µm aus der Gasphase niedergeschlagen worden ist. Bei diesem Aufwachsen bildet sich zwischen Substrat 1 und Schicht 2 eine Zwischenschicht durch Diffusion aus dem Substrat 1 aus, die in Figur 1 mit 3 bezeichnet ist. Auf das so beschichtete Substrat (1, 2, 3) ist eine aus SiO$_2$ bestehende Isolationsschicht 4 in einer Schichtdicke von kleiner 30 nm aufgewachsen, welche später in bestimmten Bereichen der Schaltung als Gateoxid verwendet wird.

Fig 2: Auf das mit der SiO$_2$-Schicht 4 versehene Substrat (1, 2, 3) wird eine aus Fotolack bestehende Implantationsmaske 5 so aufgebracht, daß die später beim Transistor fungierenden Gatebereiche frei bleiben.

Fig 3: Mit Hilfe dieser Implantationsmaske 5 wird dann eine Doppelimplantation des Kanalgebietes von aus Bor-Ionen 6 bestehenden Dotierstoffteilchen durchgeführt, wobei die tiefe Implantation (siehe Gebiet 7) gleichzeitig die Feldimplantation erzeugt. Die Verbesserung des Kurzkanaleffekts auf die Einsatzspannung und des Unterschwellenverhaltens wird durch das plateauartige Dotierprofil der Gebiete 7 und 8 erreicht, welches durch die Doppelimplantation 6 erzeugt wird. Das Gebiet 7 mit der hohen Dotierung dient zur Abschirmung des Potentials bei Source an der Oberfläche und im Volumen (SDIBL, VDIBL) gegenüber der Drain-Spannung.

Typische Implantationsparameter zur die tiefe Implantation (Gebiet 7) sind 1 bis 3 x 10$^{12}$ B cm$^{-2}$ bei 140 keV. Mit der flachen Bor-Implantation und niedrigeren Dosis wird im Gebiet 8 die Einsatzspannung des Transistors eingestellt. Typische Implantationswerte sind 2 bis 6 x 10$^{11}$ B cm$^{-2}$ bei 25 keV.

Figur 4: Nach erfolgter Bor-Doppelimplantation 6 wird die Lackmaske 5 entfernt und in bekannter Weise das Polysiliziumgate- und Elektrodenmaterial aufgebracht und die Gateelektrode 9 strukturiert. Unter Verwendung der Gateelektrode 9 als Implantationsmaske werden dann die Source/Drain-Gebiete 10 mittels einer Arsenimplantation in bekannter Weise erzeugt, wobei für die Tiefe dieser Gebiete ein Bereich von 0,3 bis 0,4 µm eingestellt wird. Wie aus der Figur 4 zu entnehmen ist, liegt das Konzentrationsmaximum (siehe gestrichelte Linie 11) hinter den Source/Draingebieten 10 (im Gegensatz zu der bei Dennard beschriebenen Struktur (Seite 263), in welcher die Source/Drain-Zonen sich tiefer in das Substrat erstrecken als die tiefe Implantation). Die Figur 4 zeigt die erfindungsgemäße Transistorstruktur mit den Source/Drain- und Gate-Anschlüssen versehen.

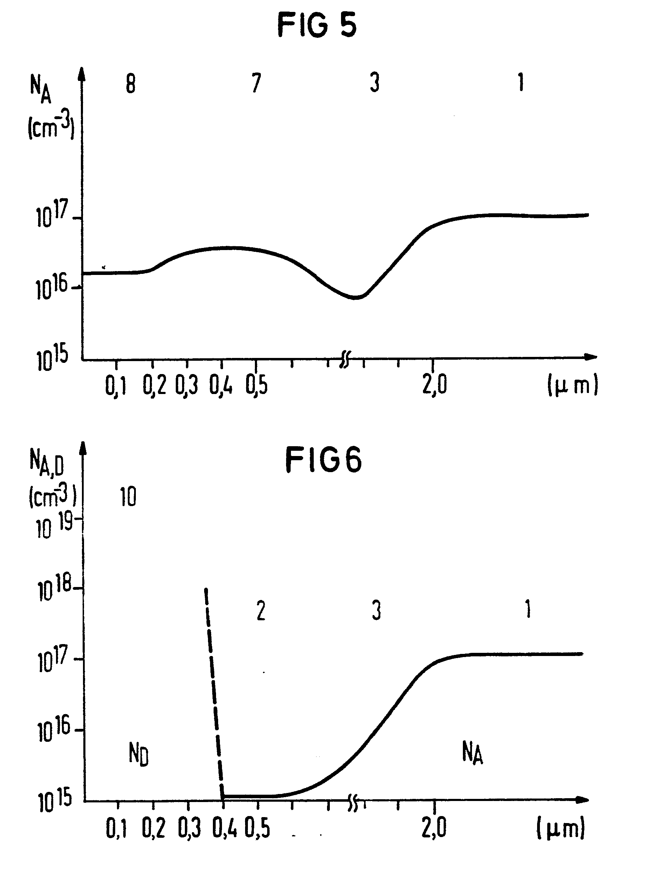

Die Figur 5 zeigt den Konzentrationsverlauf N$_A$ (cm$^{-3}$) entlang der Schnittlinie VV' in Figur 4 (Kanal-Gebiet), die Figur 6 den Konzentrationsverlauf N$_{A,D}$ (cm$^{-3}$) entlang der Schnittlinie VIVI' in Figur 4 (Source-Drain-Gebiet). In den Diagrammen sind die einzelnen Dotierungsgebiete (1, 2, 3, 7, 8 und 10) eingezeichnet. N$_A$ und N$_D$ bedeuten Akzeptor bzw. Donator-Konzentrationen.

Die Nachteile der Umkehrung des klassischen Dotierprofils, wie es beispielsweise bei Mang und Dennard beschrieben ist, auf andere Transistoreigenschaften, wie n+-Substratkapazität und Avalanche induzierter Bipolareffekte werden durch die Dotierungsgebiete 1, 2, 3 ausgeglichen. Die n+-Substratkapazität wird durch das niedrig dotierte Epitaxiegebiet 2 reduziert, bei gleichzeitiger Erhöhung der Durchbruchsspannung des pn-Überganges. Die gestrichelte Linie in Figur 6 zeigt die Lage des pn-Überganges an. Nach dem heutigen Stand der Technik kann die nicht selbstjustierende Implantationsmaske für den Kanalbereich mit einer Überlappung von 0,5 - 1,0 µm sicher justiert werden.

Durch die niederohmigen Gebiete 1, 3 wird die interne Vorspannung des Transistors und das Einschalten des parasitären Bipolartransistors verhindert. Durch den Abfall der Dotierstoffkonzentration zwischen dem Maximum 11 der Kanalimplantation und dem Substrat 1 wird die Substratsteuerung bei hohen Substratspannungen reduziert, so daß der Transistor auch als Transfergate verwendet werden kann. Der Ausläufer der Dotierstoff-Konzentration 7 sollte hierbei zur Vermeidung von Punch-Through-Effekten mit dem Ausläufer der Substratdotierung 3 überlappen.

**Patentansprüche**

1. Spannungsfester MOS-Transistor für höchstintegrierte Schaltungen mit einem Halbleitersubstrat (1) vom ersten Leitungstyp und einer darauf planar angeordneten epitaktischen Schicht (2), auf deren Oberfläche eine isolierende Schicht (4) und darauf eine aus Polysilizium bestehende Gateelektrode (9) angeordnet ist, und in der in den Oberflächenbereich hineinreichende stark-dotierte Source- und Drainzonen (10) vom zweiten Leitungstyp erzeugt sind, und in der außerdem zwischen Source- und Drainzone (10) ein als Kanalzone wirkendes Gebiet vom ersten Leitungstyp angeordnet ist, das in Richtung Substrat (1) eine unterschiedliche Konzentration von implantierten Dotierstoffteilchen aufweist, wobei

a) das Substrat (1) vom ersten Leitungstyp niederohmig und die epitaktische Schicht (2) hochohmig und vom gleichen Leitungstyp wie das Substrat (1) ist,

b) das Kanalgebiet vom ersten Leitungstyp in Richtung Substrat (1) eine zu einem Konzentrationsmaximum (11) ansteigende Dotierstoffkonzentration aufweist, wobei das Konzentrationsmaximum (11) der implantierten Dotierstoffteilchen (6) vom ersten Leitungstyp im Kanalgebiet vom ersten Leitungstyp eine größere Tiefe als die Source/Drainzonen (10) vom zweiten Leitungstyp aufweist und sich bis in die unterhalb der Source/Drainzonen (10) gelegenen Bereiche der epitaktischen Schicht (2) erstreckt, so, daß das Gebiet mit dem Konzentrationsmaximum (11) der implantierten Dotierstoffteilchen (6) den Rand der Source/Drainzonen (10) im Bereich der Gate-Elektrode (9) umschließt und

c) die epitaktische Schicht (2) eine Schichtdicke aufweist, die maximal das Zehnfache der Tiefe der Source/Drainzonen (10), aber mindestens das Doppelte der Tiefe des Konzentrationsmaximums (11) der in die Kanalzone implantierten Dotierstoffteilchen (6) beträgt.

2. MOS-Transistor nach Anspruch 1, dadurch gekennzeichnet, daß das Substrat (1) aus p-leitendem Silizium besteht und eine Dotierung im Bereich von $10^{16}$ bis $10^{17}$ B cm$^{-3}$ aufweist.

3. MOS-Transistor nach Anspruch 1 oder 2, dadurch gekennzeichnet, daß die epitaktische Schicht (2) aus p-leitendem Silizium besteht und eine Dotierung von 1 bis $2 \times 10^{15}$ B cm$^{-3}$ aufweist.

4. MOS-Transistor nach einem der Ansprüche 1 bis 3, dadurch gekennzeichnet, daß die epitaktische Schicht (2) eine Dicke im Bereich von 1,5 bis 5 µm, vorzugsweise von 2 µm aufweist.

5. MOS-Transistor nach einem der Ansprüche 1 bis 4, dadurch gekennzeichnet, daß das Konzentrationsmaximum (11) der implantierten Dotierstoffteilchen (6) in der in der epitaktischen Schicht (2) befindlichen Kanalzone 0,5 µm von der Gateisolationsschicht (4) entfernt ist.

6. MOS-Transistor nach einem der Ansprüche 1 bis 5, dadurch gekennzeichnet, daß die Tiefe der Source/Drain-Zonen (10) 0,3 bis 0,5 µm beträgt und die Source/Drain-Zonen (10) eine Dotierung aufweisen, die im Bereich von $10^{18}$ bis $10^{20}$ cm$^{-3}$ liegt.

7. MOS-Transistor nach einem der Ansprüche 1 bis 6, dadurch gekennzeichnet, daß die Dicke der aus dem Substrat (1) in die epitaktische Schicht (2) diffundierenden Zone (3) ~ 0,7 µm beträgt.

8. Verfahren zur Herstellung eines MOS-Transistors nach einem der Ansprüche 1 bis 7, bei dem folgende, an sich bekannte Verfahrensschritte ablaufen:

a) Abscheidung einer epitaktischen, p-dotierten Siliziumschicht (2) in einer Schichtdicke im Bereich von 1,5 bis 5 µm auf das aus p-leitendem Silizium bestehende, niederohmigere Substrat (1),

b) Aufwachsen einer, als Gateoxidschicht dienenden Isolationsschicht (4),

c) Aufbringen einer aus Fotolack bestehenden Implantationsmaske (5) so, daß der Gatebereich des später zu erzeugenden Transistors davon freibleib,

d) Durchführung einer Doppelimplantation (6) in den Kanalbereich durch Überlagerung einer tiefen (7) und einer flachen (8) Borionenimplantation durch Einstellung unterschiedlicher Implantationsenergien und -dosen,

e) Entfernen der Implantationsmaske (5),

f) Erzeugung und Strukturierung der aus Polysilizium bestehenden Gate-Elektrode (9),

g) Durchführung der Source/Drain-Implantation (10) unter Verwendung der Gate-Elektrode (9) als Implantationsmaske.

9. Verfahren nach Anspruch 8, dadurch gekennzeichnet, daß die Gateoxidschichtdicke (4) $d_{ox}$ auf kleiner 30 nm eingestellt wird.

10. Verfahren nach Anspruch 9, dadurch gekennzeichnet, daß die Dosis und Energie der ersten (flachen) Bor-Ionenimplantation auf 2 bis 6

x 10$^{11}$ cm$^{-2}$ und 25 keV und die Dosis und Energie der zweiten (tiefen) Bor-Ionenimplantation auf 1 bis 3 x 10$^{12}$ cm$^{-2}$ und 140 keV eingestellt wird.

**Claims**

1. A voltage-stable MOS-transistor for highly integrated circuits comprising a semiconductor substrate (1) of the first conductivity type and an epitaxial layer (2) arranged in planar fashion on the semiconductor substrate, where an insulating layer (4) is arranged on the surface of the epitaxial layer and a polysilicon gate electrode (9) is arranged on the surface of the insulating layer, and where, in the epitaxial layer (2), strongly doped source and drain zones (10) of the second conductivity type are formed which extend into the surface region and, between the source and drain zone (10) a zone of the first conductivity type is arranged which serves as a channel zone and which, in the direction of the substrate (1), has a varying concentration of implanted dopant particles, wherein
a) the substrate (1) of the first conductivity type is low-resistance and the epitaxial layer (2) is high-resistance and of the same conductivity type as the substrate (1),
b) in the direction of the substrate (1), the channel zone of the first conductivity type has a dopant concentration which increases to a concentration maximum (11), where the concentration maximum (11) of the implanted dopant particles (6) of the first conductivity type has a greater depth in the channel zone of the first conductivity type than the source/drain zones (10) of the second conductivity type and extends into those regions of the epitaxial layer (2) which are located beneath the source/drain zones (10), in such manner that the region with the concentration maximum (11) of the implanted dopant particles (6) surrounds the edge of the source/drain zones (10) in the region of the gate electrode (9),
c) the epitaxial layer (2) has a thickness which at most is ten times the depth of the source/drain zones (10) but at least double the depth of the concentration maximum (11) of the dopant particles implanted into the channel zone.

2. An MOS-transistor as claimed in Claim 1, characterised in that the substrate (1) consists of p-conducting silicon and has a doping in the range from 10$^{16}$ to 10$^{17}$ B cm$^{-3}$.

3. An MOS-transistor as claimed in Claim 1 or 2, characterised in that the epitaxial layer (2) consists of p-conducting silicon and has a doping of 1 to 2 x 10$^{15}$ B cm$^{-3}$.

4. An MOS-transistor as claimed in one of Claims 1 to 3, characterised in that the epitaxial layer (2) has a thickness in the range from 1.5 to 5 μm, preferably 2 μm.

5. An MOS-transistor as claimed in one of Claims 1 to 4, characterised in that the concentration maximum (11) of the implanted dopant particles (6) in the channel zone located in the epitaxial layer (2) is arranged at a distance of 0.5 μm from the gate insulating layer (4).

6. An MOS-transistor as claimed in one of Claims 1 to 5, characterised in that the depth of the source/drain zones (10) is 0.3 to 0.5 μm and the doping of the source/drain zones (10) is in the range of 10$^{18}$ to 10$^{20}$ cm$^{-3}$.

7. An MOS-transistor as claimed in one of Claims 1 to 6, characterised in that the thickness of the zone (3) which diffuses out of the substrate (1) into the epitaxial layer (2) is ~ 0.7 μm.

8. A process for the production of an MOS-transistor as claimed in one of Claims 1 to 7, in which the following process steps, known per se, are carried out:
a) deposition of an epitaxial, p-doped silicon layer (2), in a layer thickness in the range of from 1.5 to 5 μm, on to the low-resistance substrate (1) which consists of p-conducting silicon,
b) growth of an insulating layer (4) which serves as gate oxide layer,
c) application of a photo-resist implantation mask (5) in such manner that the gate zone of the transistor, which is later to be produced, remains exposed,
d) carrying out of a double implantation step (6) into the channel zone by super imposing a deep (7) and a shallow (8) boron ion implantation by setting different implantation energies and doses,
e) removal of the implantation mask (5),
f) formation and structuring of the polysilicon gate electrode (9),
g) carrying out of the source/drain implantation step (10) using the gate electrode (9) as implantation mask.

9. A process as claimed in Claim 8, characterised in that the gate oxide layer thickness (4) d$_{ox}$ is set at less than 30 nm.

10. A process as claimed in Claim 9, characterised in that the dose and energy of the first (shallow) boron ion implantation step are set at 2 to 6 x 10$^{11}$ cm$^{-2}$ and 25 keV respectively, and the dose and energy of the second (deep) boron ion implantation step are set at 1 to 3 x 10$^{12}$ cm$^{-2}$ and 140 keV respectively.

**Revendications**

1. Transistor MOS résistant à la tension pour circuits à très haute densité d'intégration, avec un substrat semiconducteur (1) d'un premier type de conduction et une couche épitaxiale (2) qui lui est superposée planairement, et sur la surface supérieure de laquelle sont disposées une couche isolante (4), puis une électrode de grille constituée de polysilicium (9), et dans laquelle sont créées des zones de source et de drain (10) du second type de conduction fortement dopées qui pénètrent dans la zone superficielle, et dans laquelle de plus une région du premier type de conduction agissant comme zone de canal est disposée entre les zones de source et de drain (10), et présentant en direction du substrat (1) une concentration différente de particules de matériau de dopage, dans lequel:

a) le substrat (1) du premier type de conduction est faiblement ohmique et la couche épitaxiale (2) est fortement ohmique et est du même type de conduction que le substrat (1);

b) la zone de canal du premier type de conduction présente en direction du substrat (1) une concentration en matériau de dopage qui croit à un maximum de concentration (11), le maximum de concentration (11) de particules de dopage (6) implantées du premier type de conduction présentant dans la zone de canal du premier type de conduction une plus grande profondeur que les zones de source et de drain (10) du second type de conduction et s'étendant jusque dans les zones de la couche épitaxiale (2) qui se situent sous les zones de source/de drain (10), de sorte que la région du maximum de concentration (11) de particules de dopage (6) implantées entoure la frontière des zones de source/de drain (10) dans le domaine de l'électrode de grille (9); et

c) la couche épitaxiale (2) présente une épaisseur de couche qui atteint au maximum dix fois la profondeur des zones de source/de drain (10), mais est au moins égale au double de l'épaisseur du maximum de concentration (11) des particules du matériau de dopage (6) implantées dans la zone de canal.

2. Transistor MOS suivant la revendication 1, caractérisé en ce que le substrat (1) est constitué de silicium du type de conduction p et présente un dopage dans la plage de $10^{16}$ à $10^{17}$ B $cm^{-3}$.

3. Transistor MOS suivant l'une des revendications 1 ou 2, caractérisé en ce que la couche épitaxiale (2) est constituée de silicium du type de conduction p et présente un dopage de 1 à $2 \times 10^{15}$ B $cm^{-3}$.

4. Transistor MOS suivant l'une des revendications 1 à 3, caractérisé en ce que la couche épitaxiale (2) présente une épaisseur dans la plage de 1,5 a 5 µm, de préférence de 2 µm.

5. Transistor MOS suivant l'une des revendications 1 à 4, caractérisé en ce que la concentration maximum (11) des particules de dopage (6) implantées dans la zone de canal située dans la couche épitaxiale (2) est distante de la couche d'isolation de grille de 0,5 µm.

6. Transistor MOS suivant l'une des revendications 1 à 5, caractérisé en ce que la profondeur des zones (10) de source de drain est de 0,3 à 0,5 µm et les zones (10) de source de drain présentent un dopage situé dans la plage de $10^{18}$ à $10^{20}$ $cm^{-3}$.

7. Transistor MOS suivant l'une des revendications 1 à 6, caractérisé en ce que l'épaisseur de la zone (3) de diffusion à partir du substrat (1) vers la couche épitaxiale (2) est de ≈ 0,7 µm.

8. Procédé de fabrication d'un transistor MOS suivant l'une des revendications 1 à 7 mettant en oeuvre les phases opératoires suivantes:

a) dépôt d'une couche épitaxiale (2) de silicium dopé p, d'une épaisseur de couche dans la plage de 1,5 à 5 µm sur le substrat (1) faiblement ohmique constitué de silicium,

b) croissance d'une couche isolante (4) servant de couche oxyde de grille,

c) dépôt d'un masque d'implantation (5) constitué d'une couche de résine photosensible de façon que reste libre la zone de la grille du transistor à réaliser ultérieurement,

d) exécution d'une double implantation (6) dans la zone de canal par superposition d'implantations d'ions bore profonde (7) et plate (8) par réglage d'énergie et de dosage d'implantation différents, e) enlèvement du masque d'implantation (5), f) création et structuration de l'électrode de grille (9) constituée de polysilicium, g) réalisation de l'implantation source/drain (10) en utilisant l'électrode de grille comme masque d'implantation.

9. Procédé suivant la revendication 8, caractérisé en ce que l'épaisseur de la couche d'oxyde grille (4) $d_{ox}$ est réglée inférieure à 30 nm.

10. Procédé suivant la revendication 9, caractérisé en ce que la dose et l'énergie de la première implantation d'ions bore (plate) sont de 2 à $6 \times 10^{11}$ $cm^{-2}$ et 25 KeV et que la dose et l'énergie de la seconde implantation d'ions bore (profonde) sont réglées à 1 à $3 \times 10^{12}$ $cm^{-2}$ et 140 KeV.

0 088 399

FIG 1

FIG 2

FIG 3

FIG 4

## FIG 5

## FIG 6